Europäisches Patentamt

European Patent Office

Office européen des brevets

(19)

(11) **EP 0 648 019 B1**

(12) **EUROPÄISCHE PATENTSCHRIFT**

(45) Veröffentlichungstag und Bekanntmachung des Hinweises auf die Patenterteilung:
**13.09.2006 Patentblatt 2006/37**

(51) Int Cl.:
*H03K 17/10* (2006.01)    *H03K 17/0814* (2006.01)
*H03K 19/003* (2006.01)    *H03K 19/0185* (2006.01)
*H01L 27/092* (2006.01)

(21) Anmeldenummer: **94115531.9**

(22) Anmeldetag: **01.10.1994**

(54) **CMOS-Schaltung mit erhöhter Spannungsfestigkeit**

CMOS circuit with high withstand-voltage

Circuit CMOS à tenue en tension élevée

(84) Benannte Vertragsstaaten:
**DE FR GB IT NL SE**

(30) Priorität: **09.10.1993 DE 4334513**

(43) Veröffentlichungstag der Anmeldung:
**12.04.1995 Patentblatt 1995/15**

(73) Patentinhaber: **Micronas GmbH**
**79108 Freiburg i. Br. (DE)**

(72) Erfinder:
• **Blossfeld, Lothar, Dipl.-Phys.**
**D-79874 Breitnau (DE)**
• **Theus, Ulrich, Dr.-Ing.**
**D-79194 Gundelfingen (DE)**
• **Motz, Mario, Dipl.-Ing.**
**D-79346 Endingen (DE)**

(56) Entgegenhaltungen:
**EP-A- 0 094 143**      **EP-A- 0 190 027**
**EP-A- 0 316 033**      **US-A- 5 179 297**
**US-A- 5 243 236**

## Beschreibung

Die Erfindung betrifft eine Schaltung zur Erhöhung der Spannungsfestigkeit einer CMOS-Schaltung, die mindestens eine erste und eine zweite Teilschaltung enthält, deren Betriebspotentiale unterschiedlich sind und die über einen ersten und zweiten Schaltungsknoten miteinander verkoppelt sind, vgl. den Oberbegriff des Anspruchs 1.

Üblicherweise sind CMOS-Schaltungen nur für einen zulässigen Spannungsbereich von 5 Volt ausgelegt, das heißt, daß die technologischen Herstellungsparameter und die geometrischen Auslegevorschriften der einzelnen Zonen für diesen Spannungsbereich optimiert sind. Es gibt jedoch auch Anwendungsbereiche für CMOS-Schaltungen, die außerhalb dieser üblichen 5V-Versorgung liegen und bei denen sich ein eigenes, stabiles 5V-Versorgungsnetz nicht lohnt. Derartige Anwendungsbereiche sind beispielsweise räumlich weit auseinanderliegende Schaltungen für elektronische Geber, Sensoren oder Steuereinrichtungen in industriellen oder kommerziellen Geräten. Ein wichtiger Anwendungsbereich ist der Kraftfahrzeugsektor mit einem sehr unstabilen Bordnetz von 12 V oder 24 V. Es ist zwar möglich, auf dem Chip eine geregelte Versorgungsspannung von 5 V zu erzeugen, vgl. beispielsweise die deutsche Patentschrift DE 42 42 989C1, dies vergrößert jedoch die Kristallfläche und erhöht daher die Herstellungskosten.

In vielen Fällen ist eine eigene Spannungsstabilisierung auf dem Halbleiterchip gar nicht erforderlich, wenn die Schaltung selbst relativ unempfindlich gegenüber Spannungsschwankungen ist und nur wenige Schaltungsteile die volle Spannungsfestigkeit erfordern. Im folgenden werden in einem kurzen Überblick die Hauptunterschiede der Spannungsfestigkeiten bei p- und n-Kanal-Transistoren beschrieben. Am kritischsten sind die n-Kanal-Transistoren, deren Drain-Source-Durchbruchspannung die maximal zulässige Versorgungsspannung bestimmt. Wenn die hoch dotierte Drain-Zone jedoch in eine niedrig dotierte n-Wanne zur Aufnahme einer Raumladungszone eingebettet wird, dann steigt unter den gleichen Herstellungsparametern die maximal zulässige Drain-Source-Spannung auf über 24 V an. Damit steht dem Entwickler ein spannungsfester n-Kanal-Transistor zur Verfügung.

Der p-Kanal-Transistor läßt bei einer Kanallänge unterhalb von 1,2 $\mu$m nur eine Drain-Bulk-Spannung von -5 V zu. Die maximal zulässige Drain-Bulk-Spannung steigt jedoch auf mindestens -12 V an, wenn die Kanallänge größer als 3,75 $\mu$m ist. Im folgenden wird bei den Spannungsangaben der p-Kanal-Transistoren zur Vereinfachung das negative Vorzeichen weggelassen, die Angaben sind daher betragsmäßig zu verstehen. Wenn die n-Wanne (= Bulkzone) des p-Kanal-Transistors an die Source-Elektrode angeschlossen ist, dann bezieht sich die Spannungsfestigkeit auf den Drain-Source-Strompfad in der n-Wanne. Ist die n-Wanne an einem anderen Potential angeschlossen, dann verringert sich die maximal zulässige Drain-Source-Spannung um das Differenzpotential, um das die n-Wanne höher als die Source-Elektrode liegt.

Die Spannungsfestigkeit monolithisch integrierter Schaltungen wird im wesentlichen durch Raumladungszonen im Halbleitermaterial bestimmt. Die Erfindung macht sich hierbei die Erkenntnis zunutze, daß große Spannungsdifferenzen zwischen zwei Schaltungsknoten in Stufen mittels einer ein- oder mehrstufigen p-Kanal-Kaskodeschaltung abgebaut werden können, wobei die Spannung durch die einzelnen Kaskodestufen etwa in gleich große Teilspannungen aufgeteilt wird. Die Teilspannungen müssen für sich genommen selbstverständlich kleiner als die zulässige Durchbruchspannungen der einzelnen Kaskodestufen sein. Der Arbeitsbereich jeder Kaskodestufe wird durch ein Festpotential bestimmt, an das die jeweilige Gate-Elektrode angeschlossen wird. Entsprechend der Erfindung werden für die Kaskodestufen p-Kanal-Transistoren verwendet, deren jeweiliges Wannenpotential etwa gleich dem Source-Potential ist oder geringfügig darüber liegt. Die Gate-Elektroden liegen an jeweils zugeordneten Festpotentialen, die von einer Vorspannungsquelle gebildet und in Abhängigkeit von der Höhe der Versorgungsspannung gesteuert werden. Die Steuerung soll bewirken, daß die Kaskodestufen bereits im Anlaufbereich der Versorgungsspannung voll aktiv sind. Zur Erhöhung der Spannungsfestigkeit bei der vollen Versorgungsspannung dienen im p-Kanal-Stromzweig die p-Kanal-Kaskode-Stufen und im weniger kritischen n-Kanal-Stromzweig spannungsfeste n-Kanal-Transistoren. Zudem ist in beiden Richtungen selbstverständlich auch die Verwendung von raumladungsfreien Polysiliziumwiderständen für den Signalpfad möglich.

In US-A 5,179,297 ist eine Schaltungsanordnung beschrieben, die p-Kanal-Transistoren in Kaskodeschaltung zum Abfangen der zu großen Versorgungsspannung enthält. Durch die Kaskodetransistoren wird die Versorgungsspannung für die nachfolgenden Stufen unterteilt, wodurch dort keine unzulässigen Spannungen auftreten. Beim Einschalten der Versorgungsspannung werden die Gate-Anschlußspannungen der Kaskodetransistoren mittels einer Steuerschaltung so lange auf dem minimalen oder jeweils maximalen Versorgungsspannungswert gehalten, bis die Versorgungsspannung einen ausreichenden hohen Wert erreicht hat, bei dem alle Kaskodetransistoren einen gesättigten Betriebszustand einnehmen können.

In US-A 5,243,236 ist eine hochspannungsfeste CMOS-Schaltung beschrieben, deren p- oder n-Kanal-Transistoren, je nachdem ob ein n- oder p-Substrat verwendet wird, durch eine geänderte Layout-Struktur eine höhere Spannungsdurchbruchsfestigkeit aufweisen als die üblichen Transistoren.

Aufgabe der im Anspruch 1 gekennzeichneten Erfindung ist es, für eine spannungsfeste CMOS-Schaltung mit Kaskodetransistoren eine Schutzschaltung gegenüber einem Verpolungsfehler und/oder gegenüber einer unzulässigen Überspannung anzugeben, wobei die Gesamtschaltung bereits bei einer möglichst niederen Versorgungsspannung, insbesondere beim kritischen Einschaltfall in Kraftfahrzeugbetrieb, betriebsfähig sein soll.

Die Erfindung und weitere, vorteilhafte Ausführungsformen werden nun anhand der Figuren der Zeichnung näher erläutert:

Fig. 1 zeigt schematisch als Blockschaltbild ein einfaches Ausführungsbeispiel gemäß dem Stand der Technik,

Fig. 2 zeigt den Spannungsverlauf zur Ansteuerung der Kaskodeschaltung von Fig. 1,

Fig. 3 zeigt schematisch als Blockschaltbild ein weiteres Ausführungsbeispiel gemäß dem Stand der Technik,

Fig. 4 zeigt den Spannungsverlauf zur Ansteuerung der Mehrfachkaskodeschaltung von Fig. 3,

Fig. 5 zeigt schematisch als Schnittbild die Zonen einer monolithisch integrierten Schutzschaltung,

Fig. 6 und Fig. 7 zeigen hierzu die Ersatzschaltbilder im normalen bzw. verpolten Betriebszustand,

Fig. 8 zeigt ein einfaches Ausführungsbeispiel zur Erzeugung eines Festpotentials und

Fig. 9 zeigt schließlich schematisch als Blockschaltbild ein Ausführungsbeispiel der Erfindung in Verbindung mit einer Hall-Sensorschaltung.

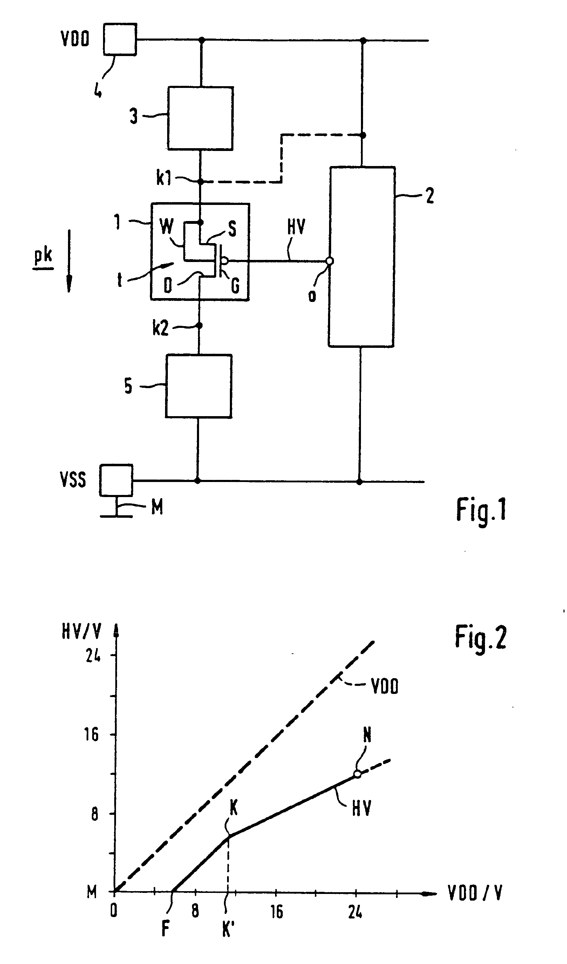

Die Schaltung von Fig. 1 zeigt einen für die Kontaktierung vorgesehenen Anschlußfleck 4, dem eine positive Versorgungsspannung VDD zugeführt ist. Mit ihr wird eine erste Teilschaltung 3 und eine Vorspannungsquelle 2 gespeist. Die erste Teilschaltung 3 weist auf der von der positiven Versorgungsspannung abgewandten Seite einen ersten Schaltungsknoten k1 auf, der mit dem positiven Eingang einer Kaskodeschaltung 1 verbunden ist. Der negative Ausgang der Kaskodeschaltung 1 ist mit einem zweiten Schaltungsknoten k2 verbunden, der zugleich der positive Schaltungseingang einer zweiten Teilschaltung 5 ist, deren negativer Schaltungsausgang an eine negative Versorgungsspannung VSS angeschlossen ist, die zugleich mit dem Massebezugspotential M verbunden ist.

Die Kaskodeschaltung 1 wird im Ausführungsbeispiel von Fig. 1 durch einen einzigen p-Kanal-Transistor t gebildet, dessen Source- und Wannenanschluß S bzw. W mit dem ersten Schaltungsknoten k1 verbunden sind und dessen Drain-Anschluß D am zweiten Schaltungsknoten k2 liegt. Der Gate-Anschluß G wird von einem Festpotential HV gespeist, das der Ausgang o einer Vorspannungsquelle 2 liefert, die entweder von der positiven Versorgungsspannung VDD oder vom Potential des ersten Schaltungsknotens k1 gespeist wird. Im folgenden wird die Kaskodeschaltung vereinfachend auch als Kaskode bezeichnet.

Beim Ausführungsbeispiel von Fig. 1 ist nicht festgelegt, welche Art von Teilschaltungen 3 und 5 über den ersten und zweiten Schaltungsknoten k1, k2 miteinander zu koppeln sind. Es findet lediglich ein Signalfluß in Form eines Stromes von der ersten Teilschaltung 3 zur zweiten Teilschaltung 5 statt. Weitere Ein- und Ausgänge der ersten und zweiten Teilschaltung 3 bzw. 5 sind in Fig. 1 nicht dargestellt.

Fig. 2 zeigt den Verlauf des Festpotentials HV, das am Ausgang o der Vorspannungsquelle 2 von Fig. 1 abgegriffen werden kann. Bei einer Versorgungsspannung von z.B. VDD = 24 V nimmt das Festpotential HV einen Wert N von ca. 12 V an. Bei abnehmender Versorgungsspannung VDD verkleinert sich das Festpotential HV proportional bis zu einem ersten Grenzwert K, dem auf der VDD-Achse der Wert K' entspricht, und nimmt von dort linear ab, bis er bei einem zweiten Grenzwert F den Massebezugspegel M erreicht.

Im Anlaufbereich der Versorgungsspannung VDD, also im Bereich zwischen 0 V und dem zweiten Grenzwert F, ist es erforderlich, daß das Festpotential HV möglichst frühzeitig auf das Massebezugspotential M geschaltet wird, damit der durch die Kaskodeschaltung 1 gebildete p-Kanal-Strompfad pk zwischen dem ersten und zweiten Schaltungsknoten k1 bzw. k2 möglichst schon bei niederen VDD-Spannungswerten voll aktiv ist. Der genaue Verlauf des Festpotentials HV zwischen dem' zweiten und ersten Grenzwert F bzw. K und schließlich dem Maximalwert N ist nur insofern vorzugeben, daß bei keinem Spannungswert VDD ein Spannungsdurchbruch erfolgt, weder in der ersten oder zweiten Teilschaltung 3 bzw. 5 noch in der Kaskode 1. Die proportionale Aufteilung der Versorgungsspannung VDD in zwei gleich große Teilspannungen erfolgt spätestens ab dem ersten Grenzwert K. In der Anordnung von Fig. 1 ist dadurch bis zu einer Versorgungsspannung VDD von 24 V kein Schaltzustand denkbar, bei dem Teilspannungen größer als 12 V sein können.

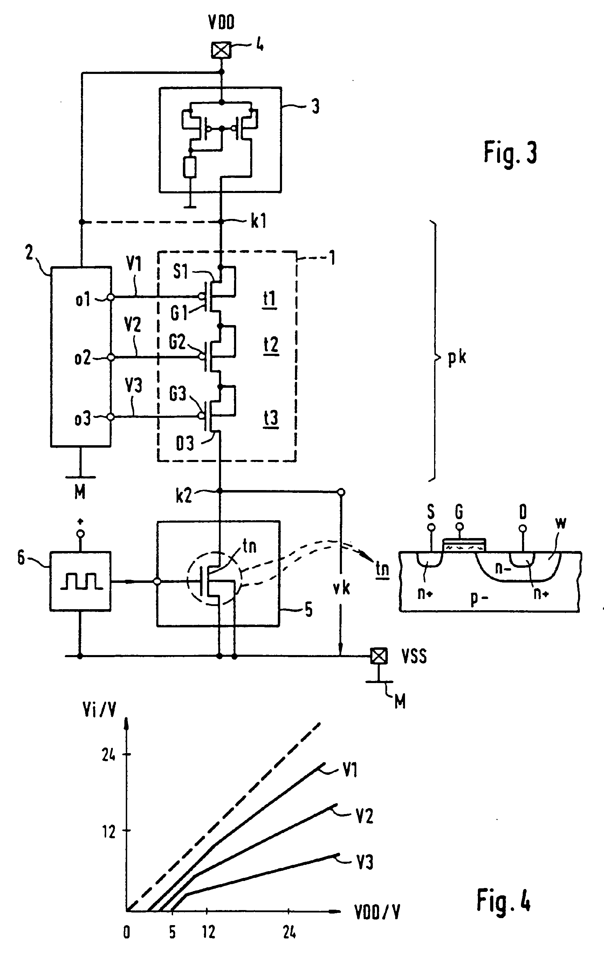

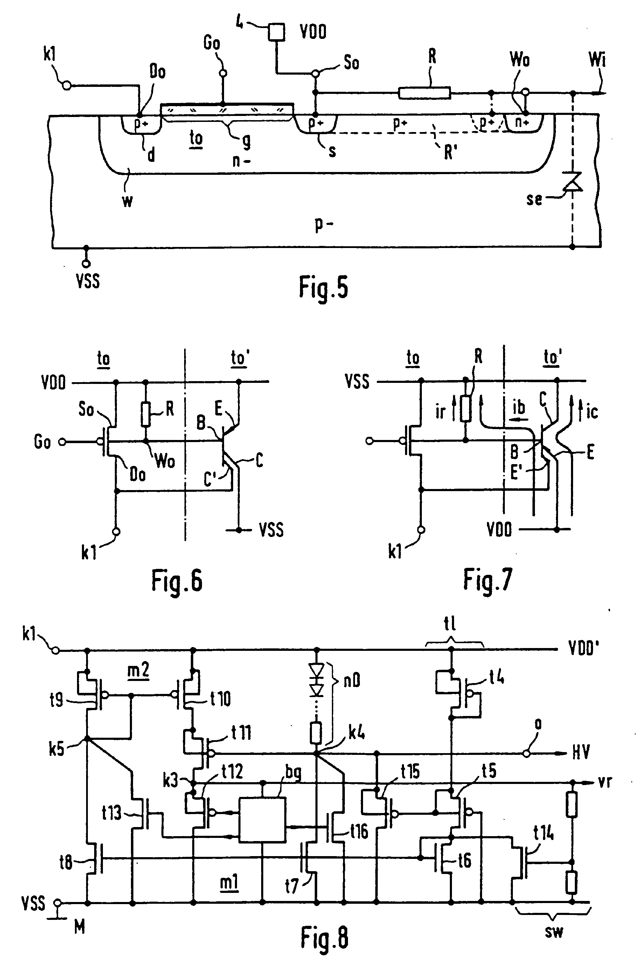

Fig. 3 zeigt schematisch eine Ausführungsform nach dem Stand der Technik, die sehr ähnlich dem Ausführungsbeispiel von Fig. 1 ist. Die Kaskodeschaltung 1 ist dabei durch eine dreistufige Kaskode ersetzt, die drei in Kaskodeanordnung zusammenwirkende p-Kanal-Transistoren t1, t2, t3 enthält. Der Source-Anschluß S1 des ersten p-Kanal-Transistors t1 ist mit dem ersten Schaltungsknoten k1 und der Drain-Anschluß D3 des dritten p-Kanal-Transistors t3 ist mit dem zweiten Schaltungsknoten k2 verbunden. Der erste bzw. zweite bzw. dritte Gate-Anschluß G1, G2, G3 ist mit einem ersten bzw. zweiten bzw. dritten Ausgang o1, o2, o3 der vorspannungsquelle 2 verbunden, die an dem jeweiligen Ausgang ein erstes bzw. zweites bzw. drittes Festpotential V1, V2, V3 liefert. Die mehrstufige Kaskodeschaltung 1 ermöglicht, daß mehr als 24 V Versorgungsspannung VDD angelegt werden können, wobei an jeder Kaskodestufe bis zu 12 V Potentialdifferenz abgebaut werden. Der zugehörige Spannungsverlauf der Festpotentiale V1, V2, V3 ist in Fig. 4 schematisch dargestellt.

In die erste Teilschaltung 3 von Fig. 3 ist als Schaltungsbeispiel ein p-Kanal-Stromspiegel eingezeichnet, dessen Ausgang mit dem ersten Schaltungsknoten k1 verbunden ist. In die zweite Teilschaltung 5 ist als Schaltungsbeispiel ein spannungsfester n-Kanal-Transistor tn eingezeichnet, dessen Drain-Anschluß mit dem zweiten Schaltungsknoten k2 verbunden ist und dessen Gate-Anschluß von einer Signalquelle 6 getaktet wird. Am zweiten Schaltungsknoten k2 ist daher eine Ausgangsspannung vk abgreifbar, die je nach Schaltzustand entweder dem Massebezugspotential M oder angenähert der positiven Versorgungsspannung VDD entspricht.

Das vereinfachte Schnittbild des spannungsfesten n-Kanal-Transistors tn ist neben der Teilschaltung 5 dargestellt. In das p-Substrat ist eine niedrig dotierte n-Wanne w eingelassen, die etwa in der Mitte eine hochdotierte (n+)-Zone enthält. Die hochdotierte (n+)-Zone und die n-Wanne w bilden gemeinsam die Drain-Zone des n-Kanal-Transistors tn. Der Source-Anschluß S ist wie üblich durch eine hochdotierte (n+)-Zone gebildet und zwischen dem Source- und dem Drain-Anschluß S bzw. D erstreckt sich die Gate-Zone mit dem Gate-Anschluß G. Da der hochdotierte Teil der Drain-Zone von der niedrig dotierten n-Wanne umgeben ist, kann sich in dieser eine Raumladungszone ausbilden, die die maximale Feldstärke im Halbleitermaterial niedrig hält. Andernfalls käme es zum Durchbruch an der Sperrschichtgrenze zwischen dem p-leitenden Substrat und der hochdotierten (n+)-Zone.

In Fig. 5 ist die erste Teilschaltung 3 als Schutzschaltung gegenüber einem Verpolungsfehler von positiver und negativer Versorgungsspannung VDD bzw. VSS ausgebildet. Zusätzlich enthält die Schutzschaltung ein Überspannungs-Schutzelement se. Die Funktionsweise des Verpolungsschutzes wird anhand des Schnittbildes Fig. 5 durch die verschiedenen Halbleiterzonen und die beiden Ersatzschaltbilder Fig. 6 und Fig. 7 erläutert. Der wesentliche Teil der Schutzschaltung besteht aus einer p-Kanal-Transistorstruktur to mit Drain-, Gate- und Source-Zone d bzw. g bzw. s. Diese Zonen sind in eine n-Wanne w eingelassen. Die n-Wanne w ist mittels einer hochdotierten (n+)-Zone kontaktiert. Die Besonderheit dieser Schutzschaltung besteht nun darin, daß der Wannenanschluß Wo über einen ohm'schen Widerstand R mit dem Source-Anschluß So verbunden ist. Anstatt des Widerstandes R kann auch eine speziell ausgebildete Zone in der n-Wanne w selbst dienen. Dies wird beispielsweise dadurch erreicht, daß die (p+)-leitende Source-Zone s als eine Widerstandszone R' erweitert wird, die den Source-Anschluß So über diesen Widerstand R' mit dem Wannenanschluß Wo verbindet. Die in Fig. 5 dargestellte Schutzschaltung ist Gegenstand einer zeitgleichen deutschen Patentschrift DE 43 34 515 C1 und es wird ausdrücklich auf die dortige, ausführliche Beschreibung verwiesen.

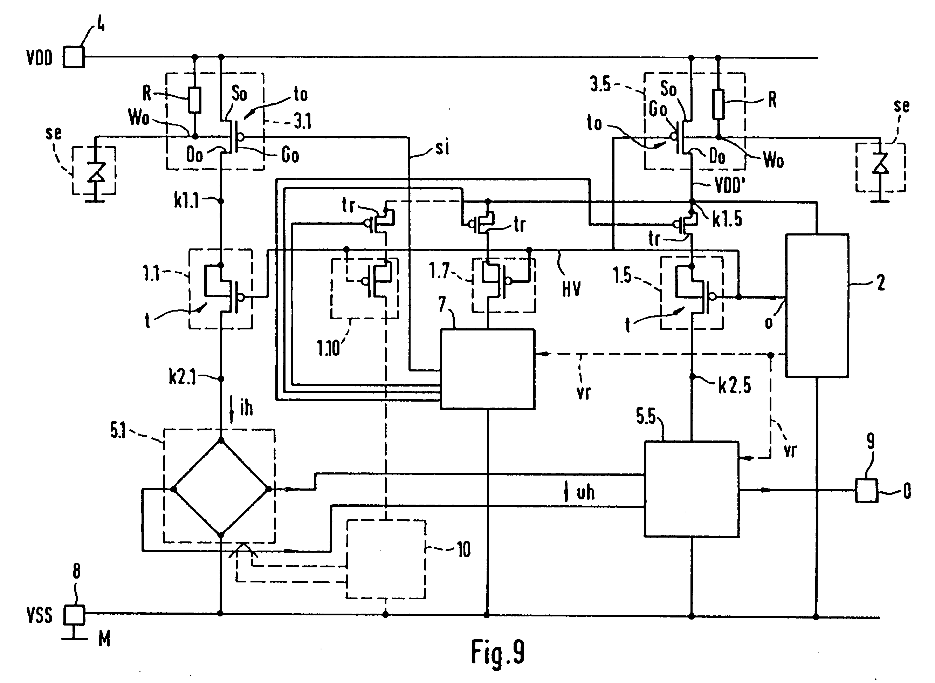

Der normale Betriebszustand ist wie folgt definiert: Der mit der positiven Versorgungsspannung VDD gespeiste Anschlußfleck 4 ist niederohmig mit dem Source-Anschluß So verbunden. Der Drain-Anschluß Do speist den ersten Schaltungsknoten k1, der der weiteren internen Spannungsversorgung dient. Die Ansteuerung des Gate-Anschlusses Go erfolgt entweder mittels eines Schaltsignals oder mittels eines Regelsignals. Beim Schaltsignal wird die p-Kanal-Transistorstruktur to durchschaltet, so daß das Potential VDD' am ersten Schaltungsknoten k1 nahezu der positiven Versorgungsspannung VDD gleich ist. Beim Regelsignal dient die p-Kanal-Transistorstruktur to zum Regeln des am ersten Schaltungsknoten k1 abgreifbaren Stromes. Beide Anwendungen sind im Ausführungsbeispiel von Fig. 9 realisiert. Da durch den Widerstand R bzw. R' die n-Wanne w ebenfalls an die positive Versorgungsspannung VDD angeschlossen ist, ist die sichere Betriebsweise der p-Kanal-Transistorstruktur to sichergestellt.

Fig. 6 zeigt das Ersatzschaltbild von Fig. 5 im normalen Betriebsfall. Der pnp-Ersatztransistor to' ist wie folgt gebildet: die Source-Zone s bildet den Emitter E, die n-Wanne w bildet die Basis B, der Substratbereich bildet den Kollektor C und die Drain-Zone d bildet schließlich einen lateralen Kollektor C'. Wenn die Source-Zone s zur Bildung des Widerstandes R' erweitert wird, dann bildet selbstverständlich die gesamte (p+)-Zone den Emitter E. Im normalen Betriebszustand ist der Ersatztransistor to' gesperrt, weil die Basis B und der Emitter E über den stromlosen Widerstand R bzw. R' kurzgeschlossen sind.

Im Verpolungsfall ist die aus Substrat und n-Wanne w gebildete pn-Diode in Flußrichtung gepolt. Nun tritt der Widerstand R bzw. R' in Aktion. Der Wannenstrom kann nicht direkt über den Anschlußfleck 4 abfließen, sondern er muß über den Widerstand R bzw. R' fließen, dadurch wird sein Wert begrenzt. Die Auswirkungen dieses Widerstandes R bzw. R' werden anhand der in Fig. 7 dargestellten Ersatzschaltung erläutert, die den invers betriebenen pnp-Ersatztransistor to' enthält. Durch die Verpolung ändern sich die Elektrodenzuordnungen zwischen der p-Kanal-Transistorstruktur to und dem pnp-Ersatztransistor to' wie folgt: der Substratbereich bildet einen Emitter E, der auch als Hauptemitter anzusprechen ist, die lateral liegende Drain-Zone d bildet einen lateralen Emitter E', die n-Wanne w bildet nach wie vor die Basis B und die Source-Zone s, gegebenenfalls zusammen mit der (p+)-Erweiterung für den Widerstand R', bildet schließlich einen einzigen Kollektor C. Gegenüber Fig. 6 liegt in Fig. 7 ein inverser Betrieb des pnp-Ersatztransistors to' vor. Der in Fig. 7 eingezeichnete Kollektorstrom ic ergibt sich angenähert aus folgender Transistorgleichung:

$$ic = Binv \times ib,$$

dabei ist "ib"= der Basisstrom, "ir" = ist der Strom über den Widerstand R und "Binv"= ist der inverse Gleichstromverstärkungsfaktor des pnp-Ersatztransistors to'. Der laterale Emitter E' ist in seiner Wirkung vernachlässigbar, weil der größte Teil des Wannenstromes durch die in Flußrichtung gepolte, großflächige Wannen-Substratdiode verursacht wird. Die obige Gleichung zeigt, daß der maximal auftretende Verpolungsstrom sowohl von dem inversen Stromverstärkungsfaktor Binv als auch der Größe des Basisstromes ib und damit auch vom Widerstand R abhängig ist. Durch die Schaltungsgeometrie und die Dotierung der jeweiligen Zonen wird erreicht, daß der inverse Stromverstärkungsfaktor etwa in der Größenordnung von 1 oder sogar noch darunter liegt. Kritisch können jedoch die Ströme sein, die über die anderen n-Wannen der Gesamtschaltung fließen, wenn eine große Anzahl dieser Wannenanschlüsse Wi ebenfalls über den Widerstand R angeschlossen sind. Diese Ströme addieren sich zu dem Widerstandsstrom ir, vergrößern jedoch nicht den Basisstrom ib des pnp-Ersatztransistors to'.

Wird bei der Schutzschaltung nach Fig. 5 ein Überspannungs-Schutzelement se zum Abfangen zu großer Versorgungsspannungen VDD vorgesehen, dann wird dieses Element ebenfalls am Wannenkontakt Wo angeschlossen. Beispielsweise eignet sich für ein derartiges Überspannungs-Schutzelement se eine vergrabene Z-Diode, die mittels der zugehörigen Zonen in die Halbleiteroberfläche eingelassen ist und deren Abbruchspannung durch den Herstellungsprozeß relativ genau einstellbar ist. Als Überspannungs-Schutzelement se eignet sich aber auch ein Feldoxidtransistor, dessen Schaltschwelle durch die Feldoxiddicke in weiten Grenzen einstellbar ist, so daß er bei Überspannungen leitend wird und die Ladungen niederohmig nach dem Massepotential abfließen läßt. Ein derartiger Transistor ist als n-Kanal-Transistor wie folgt anzuschließen: Source- und Bulk-Anschluß liegen auf dem Massebezugspotential M und der Gate- und Drain-Anschluß sind niederohmig mit dem Wannenanschluß Wo verbunden. Bei einer zulässigen Versorgungsspannung VDD von 24 V ist beispielsweise ein Überspannungs-Schutzelement se vorzusehen, dessen Abbruchspannung zwischen 27 V und 32 V liegt. Wenn ein eigener Anschlußfleck für den Wannenkontakt Wo vorliegt, kann selbstverständlich auch ein äußeres Überspannungs-Schutzelement vorgesehen werden.

In Fig. 8 ist ein einfaches Ausführungsbeispiel für die Vorspannungsquelle 2 von Fig. 1 im Schaltbild dargestellt. Am Ausgang o soll das Festpotential HV abgreifbar sein. Die Schaltung bewirkt, daß der Verlauf des Festpotentials HV etwa dem idealisierten Verlauf von Fig. 2 entspricht. Die Vorspannungsquelle 2 liegt zwischen dem ersten Schaltungsknoten k1 und der negativen Versorgungsspannung VSS, wobei der erste Schaltungsknoten k1 mit der Spannung VDD' nahezu die positive Versorgungsspannung VDD aufweist. Die Klemmung des Festpotentials auf das Massebezugspotential M im Anlaufbereich erfolgt durch die Aktivierung eines Transistors t7 mittels einer ersten Strombank m1. Deren Eingang wird von einem Spannungsteiler t1 gespeist, der als Gleichstrompfad zwischen dem ersten Schaltungsknoten k1 und dem Strombankeingang liegt und dessen Widerstände durch zwei in Reihe geschaltete p-Kanal-Transistoren t4, t5 gebildet sind. Der Drain-Anschluß des Transistors t5 ist der Fußpunkt des Spannungsteilers t1 und speist den zusammengeschalteten Drain-Gate-Anschluß eines n-Kanal-Transistors t6, der als Strombankeingang dient. Zur Sicherung der Spannungsfestigkeit sind die Wannenanschlüsse der Transistoren t4 und t5 an die jeweiligen SourceElektroden angeschlossen.

Die erste Strombank m1 ist aus den n-Kanal-Transistoren t6, t7, t8 gebildet. Der Drain-Anschluß des Transistors t7 ist über einen vierten Schaltungsknoten k4 an eine relativ hochohmige Diodenkette nD angeschlossen, die ähnlich wie der Spannungsteiler t1 aus in Serie geschalteten p-Kanal-Transistoren bestehen kann, wobei das jeweilige W/L-Verhältnis der Gate-Zonen aber einen höheren Wert hat als beim Spannungsteiler t1. Das abgewandte Ende der Diodenkette nD liegt am ersten Schaltungsknoten k1. Das Stromübersetzungsverhältnis der ersten Strombank m1 ist so ausgelegt, daß im Anlaufbereich, etwa bis zum zweiten Grenzwert F, der Transistor t7 die Diodenkette nD bis auf das Massebezugspotential M durchschalten kann.

Der durch den Transistor t8 gebildete zweite Ausgang der ersten Strombank m1 ist über einen fünften Schaltungsknoten k5 auf den Eingang einer zweiten Strombank m2 geführt. Deren Ein- bzw. Ausgang ist aus jeweils einem p-Kanal-Transistor t9 bzw. t10 gebildet. Der Drain-Anschluß des Transistors t10 ist über eine Kaskodeschaltung aus einem p-Kanal-Transistor t11 auf einen dritten Schaltungsknoten k3 geführt und zieht als pull-up-Element diesen dritten Schaltungsknoten k3 in positive Spannungsrichtung. Am dritten Schaltungsknoten k3 kann in Verbindung mit dem Ausgangstransistor t12 einer Bandgap-Schaltung bg eine geregelte Hilfsspannung, nämlich eine Bandgap-Ausgangsspannung vr von beispielsweise 3,8 V, abgegriffen werden. Die durch den Transistor t11 gebildete Kaskode, die zur Erhöhung der Spannungsfestigkeit zwischen dem Transistor t10 und dem dritten Schaltungsknoten k3 dient, ist mit ihrem Gate-Anschluß an das Festpotential HV angeschlossen. Da im Anlaufbereich das Festpotential HV auf dem Massebezugspotential M liegt, befindet sich der p-Kanal-Transistor t11 im Schalterbetrieb und ist voll durchgeschaltet.

Als pull-down-Element für den dritten Schaltungsknoten k3 dient der bereits genannte Transistor t12, der in Fig. 8 beispielsweise mittels eines p-Kanal-Transistors ausgebildet ist. Die Gate-Elektrode dieses Transistors wird von einem Ausgang der Bandgap-Schaltung bg angesteuert, deren versorgungsspannungs- und Referenzeingang direkt mit dem dritten Schaltungsknoten k3 verbunden sind. Eine geeignete Bandgap-Schaltung bg ist beispielsweise sehr ausführlich in der bereits genannten deutschen Patentschrift DE 42 42 989 C1 beschrieben. Bei geringerer Anforderung an die geregelte Spannung vr genügt selbstverständlich auch eine einfachere Schaltung zur Aktivierung des pull-down-Elements t12.

Wenn im Anlaufbereich der positiven Versorgungsspannung VDD die Bandgap-Schaltung bg noch nicht aktiv ist, dann ist auch das pull-down-Element t12 noch nicht aktiv. Der dritte Schaltungsknoten k3 nimmt daher ein Potential vr ein, das etwas unter der jeweiligen Versorgungsspannung VDD' liegt. Wenn die Spannung vr groß genug geworden ist, so daß die Bandgap-Schaltung bg in den Betriebsbereich kommt, dann kann die Bandgap-Ausgangsspannung vr durch das Regelverhalten nur noch bis zu dem beispielsweise genannten Regelwert von 3,8 V ansteigen. Ein weiterer Ausgang der Bandgap-Schaltung bg steuert dabei den Gate-Anschluß eines n-Kanal-Transistors t13, dessen Drain-Anschluß auf den fünften Schaltungsknoten k5 geführt ist. Mittels des Transistors t13 wird die zweite Strombank m2 mit einem zusätzlichen Eingangsstrom angesteuert. Dieser Strom ersetzt später den Eingangsstrom aus der ersten Strombank ml, der nach Anlauf der Referenzspannung vr, die zugleich die Bandgap-Ausgangsspannung ist, in der Regel unterhalb des zweiten Grenzwertes F abgeschaltet wird.

Die Realisierung des etwa linearen Spannungsverlaufs des Festpotentials HV zwischen dem zweiten und ersten Grenzwert F bzw. K (vgl. Fig. 2) wird mittels eines n-Kanal-Transistors t16 bewirkt, der von einem weiteren Ausgang der Bandgap-Schaltung bg angesteuert wird. Transistor t16 belastet den Schaltungsknoten k4 in diesem Bereich F, K mit einem Konstantstrom, zu dem ab dem Grenzwert K der Strom des Source-Folgers t15 hinzukommt.

Mit der Betriebsaufnahme der Bandgap-Schaltung bg, deren geregelte Ausgangsspannung vr auch anderen Schaltungsteilen der Gesamtschaltung dient, vgl. beispielsweise Fig. 9, ist ein sicherer Betriebszustand erreicht, bei dem die Gesamtschaltung nicht mehr in einem undefinierten Zustand hängen bleiben kann, auch wenn die Versorgungsspannung VDD noch relativ niedrig ist. Ein undefinierter Betriebszustand könnte beispielsweise bei voller Versorgungsspannung VDD zu Zerstörungen führen, wenn das Festpotential HV für die Kaskodeschaltungen auf einen falschen Spannungswert eingerastet ist. Die Feststellung des regulären Betriebsbereiches erfolgt in Fig. 8 durch eine Schalteranordnung sw mit einem n-Kanal-Transistor t14, der über einen eine Schaltschwelle bestimmenden Spannungsteiler von der Bandgap-Ausgangsspannung vr angesteuert wird. Sowie diese Spannung vr einen bestimmten Schwellenwert überschreitet, wird Transistor t14 leitend und schaltet die erste Strombank m1 ab, indem der Fußpunkt des Spannungsteilers t1 auf das Massebezugspotential M geschaltet wird. In der Regel sollte die Schaltschwelle so eingestellt sein, daß Transistor t14 bereits unterhalb des Grenzwertes F schaltet - sofern die Bandgap-Schaltung bg bereits in Betrieb ist.

Der besseren Übersicht wegen ist in Fig. 8 die Schalteranordnung sw an die Bandgap-Ausgangsspannung vr angeschlossen. Zweckmäßiger ist es jedoch, wenn die Schalteraktivierung von einem Strompfad der Bandgap-Schaltung bg ausgelöst wird, und zwar durch den zuletzt einsetzenden Strompfad, weil dann sichergestellt ist, daß alle wichtigen Teilschaltungen bereits aktiv sind. Eine Schaltungsanordnung, die dies bewirkt, ist beispielsweise in der bereits genannten deutschen Patentschrift DE 42 42 989 C1 im Zusammenhang mit einer Anlaufschaltung beschrieben.

Durch die Abschaltung der ersten Strombank m1 werden deren Ausgangstransistoren t7, t8 stromlos. Damit zieht die Diodenkette nD das Potential des vierten Schaltungsknotens k4 vom bisherigen Massebezugspotential M auf ein höheres Potential. Den Eingangsstrom für die zweite Strombank m2 liefert, wie bereits besprochen, der von der Bandgap-Schaltung bg gesteuerte Transistor t13. Da die Spannung am vierten Schaltungsknoten k4 letztendlich das Festpotential HV darstellt, das im Regelfall der halben Versorgungsspannung VDD/2 entsprechen soll, muß der Spannungspegel des vierten Schaltungsknoten k4 niederohmig fixiert werden. Dies erfolgt mittels eines Sourcefolgers aus einem p-Kanal-Transistor t15, dessen Gate-Anschluß am Mittelabgriff des Spannungsteilers t1 liegt. Damit ist das Festpotential HV stabilisiert und kann die verschiedenen Kaskodeschaltungen, z.B. auch Transistor t11, bezüglich ihrer Gate-Potentiale festlegen. Die Anbindung des Festpotentials HV an den Spannungsteilerabgriff bewirkt die proportionale Abhängigkeit von VDD ab dem Grenzwert K. Der Übergangsbereich zwischen dem zweiten Grenzwert F und ersten Grenzwert K ist, wie bereits beschrieben, von den Schaltschwellen und dem Stromübernahmeverhalten der beteiligten Stufen abhängig. Sind von der Vorspannungsquelle 2 mehrere Festpotentiale V1, V2, V3 wie in Fig. 3 zu erzeugen, dann enthält der Spannungsteiler t1 die entsprechenden Spannungsabgriffe, an die jeweils ein Source-Folger angeschlossen ist. Jedes Festpotential enthält dabei eine eigene, relativ hochohmige pull-up-Anordnung.

Fig. 9 zeigt ein Ausführungsbeispiel der Erfindung in Verbindung mit einer Hall-Sensorschaltung, die direkt an eine ungeregelte Versorgungsspannung von 24 V angeschlossen werden kann. Zudem ist die Hall-Sensorschaltung gegen einen Verpolungsfehler der positiven und negativen Versorgungsspannung VDD bzw. VSS geschützt. Zusätzlich enthält die Schaltung von Fig. 9, jeweils ein Überspannungs-Schutzelement se am Wannenanschluß Wo der beiden p-Kanal-Transistorstrukturen to. Bei der in Fig. 9 dargestellten Hall-Sensorschaltung handelt es sich um ein Bauelement mit drei Anschlußklemmen, denen die Anschlußflecke 4, 8 und 9 für die positive Versorgungsspannung VDD, die negative Versorgungsspannung VSS und das Ausgangssignal O zugeordnet sind.

An den Anschlußfleck 4 ist niederohmig eine geregelte Schutzschaltung 3.1 und eine geschaltete Schutzschaltung 3.5 angeschlossen. Die geregelte Schutzschaltung 3.1 erzeugt einen Betriebsstrom ir für eine monolithisch mitintegrierte Hall-Platte 5.1, deren Fußpunkt am Massebezugspotential M liegt. Den Ausgang der geregelten Schutzschaltung 3.1 bildet ein erster Schaltungsknoten k1.1 und den Eingang für den Betriebsstrom ih der Hall-Platte bildet ein zweiter Schaltungsknoten k2.1. Die ca 20 V große Differenzspannung zwischen dem ersten und zweiten Schaltungsknoten k1.1, k2.1 wird durch eine Kaskodeschaltung 1.1 überwunden, die von einem p-Kanal-Transistor t gebildet wird, dessen Gate-Anschluß an einem Festpotential HV von etwa 12 V liegt, das eine Vorspannungsquelle 2 am Ausgang o liefert. Die Vorspannungsquelle 2 kann dabei durch eine Schaltung entsprechend Fig. 8 realisiert sein. Der geregelte Betriebsstrom ih für die Hall-Platte 5.1 wird durch die Ansteuerung des Gate-Anschlusses Go der geregelten Schutzschaltung 3.1 mittels eines Regelsignals si bewirkt, das eine Regelschaltung 7 liefert. In der geregelten Schutzschaltung 3.1 ist die p-Kanal-Transistorstruktur to mit dem Widerstand R für den Wannen-Anschluß Wo und dem Source- und Drain-Anschluß So bzw. Do (vgl. Fig. 5) schematisch dargestellt.

Die ebenfalls niederohmig mit dem Anschlußfleck 4 verbundene geschaltete Schutzschaltung 3.5 enthält grundsätzlich die gleichen Elemente wie die geregelte Schutzschaltung 3.1. An ihrem Ausgangsknoten k1.5, ist eine positive Versorgungsspannung VDD' abgreifbar, die nur unwesentlich unter dem Potential VDD des Anschlußflecks 4 liegt. Dies ergibt sich, weil der Gate-Anschluß Go dieser p-Kanal-Transistorstruktur to am Festpotential HV angeschlossen ist und damit die p-Kanal-Transistorstruktur to als Schaltelement voll durchschaltet. Der Schaltungsknoten k1.5 dient daher als interner Anschlußpunkt für die positive Versorgungsspannung VDD' der CMOS-Schaltung. Ein Teil dieser Schaltung wird durch eine analoge und/oder digitale Signalverarbeitungsschaltung 5.5 realisiert, deren Eingänge mit der Hall-Spannungsdifferenz uh gespeist sind. Diese Spannungsdifferenz uh wird an den Spannungsabgriffen der Hall-Platte 5.1 abgenommen. Die Auswertung der Hall-Spannungsdifferenz uh in der Schaltung 5.1 kann analog, digital oder in gemischter Form erfolgen. Im Beispiel von Fig. 9 ist nur eine einzige Ausgangsklemme 9 für das Ausgangssignal O vorhanden. Im einfachsten Fall arbeitet die Hall-Sensorschaltung als Schalter und stellt an der Ausgangsklemme 9 ein Schaltsignal zur Verfügung, wenn das von der Hall-Platte gemessene Magnetfeld einen bestimmten Wert über- oder unterschreitet. Für diese Anwendung ist lediglich ein kostengünstiges, dreibeiniges Gehäuse erforderlich, das jedoch die Gefahr eines Verpolungsfehlers einschließt. Durch die beiden Schutzschaltungen 3.1 bzw. 3.5 hat dieser Verpolungsfehler jedoch keine negative Folgen für die Funktion des Bauelements.

Die Spannungsversorgung der Schaltung 5.5 erfolgt über die einstufige Kaskode 1.5, die zwischen den ersten und zweiten Schaltungsknoten k1.5 und k2.5 als p-Kanal-Strompfad eingefügt ist. Der zugehörige p-Kanal-Transistor t hängt mit seinem Gate-Anschluß am Festpotential HV. Entsprechend ist die Regelschaltung 7 und eine gegebenenfalls vorhandene Steuerschaltung 10 jeweils über eine Kaskodeschaltung 1.7 bzw. 1.10 zur Spannungs- und Stromversorgung an den Schaltungsknoten k1.5 angeschlossen. Die Regelschaltung 7 und die Auswerteschaltung 5.5 sind gegebenenfalls an die geregelte Bandgap-Ausgangsspannung vr der Vorspannungsquelle 2 angeschlossen. In der Regelschaltung 7 dient die Bandgap-Ausgangsspannung vr als Referenzspannung, um mittels einer Nachbildung der Hall-Platte den Betriebsstrom ih zu regeln. In der Auswerteschaltung 5.5 dient die Bandgap-Ausgangsspannung vr als eine Spannungsreferenz für die Hall-Differenzspannung uh, um beispielsweise die Schaltfunktion an der Ausgangsklemme 9 zu steuern. Die Hall-Platte 5.1 ist in Fig. 9 lediglich ganz schematisch dargestellt, selbstverständlich kann es sich dabei um eine Mehrfach-Hall-Plattenanordnung handeln, deren jeweilige Betriebsströme und Spannungsabgriffe von der Steuerschaltung 10 zyklisch umgeschaltet werden, vgl. beispielsweise die europäische Patentanmeldung EP-A 0 548 391.

In Fig. 9 ist zwischen den Schaltungsknoten k1.5 und die jeweilige Kaskodeschaltung 1.10, 1.7, 1.5 jeweils ein p-Kanal-Transistor tr eingefügt, dessen Gate von jeweils einem Ausgang der Regelschaltung 7 gesteuert wird. Diese Anordnung erlaubt es, daß die gegen Reversebetrieb geschützte Schutzschaltung 3.5 nur einmal vorhanden sein muß. Die individuelle Regelung der Ströme kann dann auf einfache Weise durch die gewöhnlichen p-Kanal-Transistoren tr erfolgen, die nicht mehr gegen den zerstörenden Reversbetrieb geschützt werden müssen. Es wird darauf hingewiesen, daß die geregelte Schutzschaltung 3.1 prinzipiell auf gleiche Weise durch einen an den Knoten k1.5 angeschlossenen p-Kanal-Transistor tr ersetzt werden könnte. Wegen der großen Betriebsströme ih der Hall-Platte 5.1 wäre dies jedoch nicht zweckmäßig.

**Patentansprüche**

1.  Schaltung (to, 1) zur Erhöhung der Spannungsfestigkeit einer CMOS-Schaltung (3,5), die mindestens eine erste und eine zweite Teilschaltung (3,5) enthält, deren Betriebspotentiale unterschiedlich sind und die über einen ersten und einen zweiten Schaltungsknoten (k1, k2) miteinander verkoppelt sind, wobei

    - zum Abfangen der Spannung eine Kaskodeschaltung (1) dient, die zwischen dem ersten und zweiten Schaltungsknoten (k1, k2) eingefügt ist und mindestens einen in Kaskodeanordnung geschalteten p-Kanal-Transistor (t) enthält,
    - der mindestens eine p-Kanal-Transistor (t) mittels seines Source-Anschlußes (S) mit dem ersten Schaltungsknoten (k1), seines Drain-Anschlußes (D) mit dem zweiten Schaltungsknoten (k2), und seines Gate-Anschlußes (G) mit dem zugehörigen Ausgang (o) einer Vorspannungquelle (2) verbunden ist, die an dem Gate des mindestens einen in Kaskodeanordnung geschalteten p-Kanal-Transistors (t) ein Festpotential (HV) erzeugt, das zwischen einer positiven Versorgungsspannung (VDD) und einer negativen Versorgungsspannung (VSS) liegt,
- der Wannenanschluß (W) des mindestens einen p-Kanal-Transistors (t) mit einem Anschlußpotential verbunden ist, das dem jeweiligen Source-Potential im wesentlichen gleich ist oder geringfügig drüber liegt, und
- die Vorspannungsquelle (2) das oder die Festpotentiale (HV bzw. V1, V2, V3) in Abhängigkeit von der Höhe der positiven Versorgungsspannung (VDD) derart erzeugt, daß während eines Einschaltvorganges der positiven Versorgungsspannung (VDD), in dem die hochlaufende positive Versorgungsspannung (VDD) zwischen den Spannungswerten 0V und einem weiteren Spannungswert, der einem zweiten Grenzwert (F) gleich ist, liegt, das oder die Festpotentiale (HV; V1, V2, V3) der negativen Versorgungsspannung (VSS) gleich sind und daß außerhalb dieser Spannungswerte (0V, F) mit zunehmender Höhe der positiven versorgungsspannung (VDD) das oder die Festpotentiale (HV; V1, V2, V3) derart mit der Versorgungsspannung ansteigen, daß bei keinem Spannungswert der positiven Versorgungsspannung (VDD) ein Spannungsdurchbruch erfolgt,

**gekennzeichnet durch folgende Merkmale:**

- die erste Teilschaltung (3; 3.1, 3.5) enthält zwischen einem Anschluß (4) für die positive Versorgungsspannung (VDD) und dem ersten Schaltungsknoten (k1) eine in eine n-Wanne (w) eingelassene p-Kanal-Transistorstruktur (to) mit einer Source-, Drain- und Gate-Zone (s bzw. d bzw. g), wobei die n-Wanne (w) über einen Widerstand (R; R'), der der Strombegrenzung im Verpolungsfall dient, mit dem Source-Anschluß (So) der p-Kanal-Transistorstruktur (to) verbunden ist, der niederohmig an die positive Versorgungsspannung (VDD) gekoppelt ist,
- der Drain-Anschluß (Do) der p-Kanal-Transistorstruktur (to) ist an den ersten Schaltungsknoten (k1) gekoppelt und
- der Gate-Anschluß (Go) der p-Kanal-Transistorstruktur (to) ist bei einer geschalteten Schutzschaltung (3.5) mit einem der Festpotentiale (VH; V1, V2, V3) aus der Vorspannungsquelle (2) und bei einer geregelten Schutzschaltung (3.1) mit dem Ausgangssignal einer Regelschaltung (7) gespeist, die den Ausgangsstrom (ih) der geregelten Schutzschaltung (3.1), der insbesondere über die Kaskodeschaltung (1) fließt, regelt.

2. Schaltung nach Anspruch 1, **dadurch gekennzeichnet, daß** die Vorspannungsquelle (2) spätestens beim Erreichen des Maximalwertes der positiven Versorgungsspannung (VDD) die Höhe des oder der Festpotentiale HV bzw. V1, V2, V3) in der Weise festlegt, daß sie bezüglich der jeweils vorhandenen Versorgungsspannung im wesentlichen gleich große Abschnitte definieren.

3. Schaltung nach Anspruch 1, **dadurch gekennzeichnet, daß** der mittels der Regelschaltung (7) geregelte Strom der Betriebsstrom (ih) einer mitintegrierten Hall-Platte (5.1) ist.

4. Schaltung nach einem der Ansprüche 1 bis 3, **dadurch gekennzeichnet, daß** die zweite Teilschaltung (5) eine analoge und/oder digitale Signalverarbeitungsschaltung enthält.

5. Schaltung nach einem der Ansprüche 1 bis 4, **dadurch gekennzeichnet, daß** die zweite Teilschaltung (5) mindestens einen spannungsfesten n-Kanal-Transistor (tn) enthält.

6. Schaltung nach Anspruch 1, **dadurch gekennzeichnet, daß** die Schutzschaltung (3.1; 3.5) an ihrem Wannenanschluß (Wo) mit einer Z-Diode oder mit einem Feldoxidtransistor als Überspannungs-Schutzelement (se) verbunden ist.

**Claims**

1. A circuitry (to, 1) for increasing the electric strength of a CMOS circuit (3, 5) comprising at least first and second subcircuits (3, 5) which have different operating potentials and are coupled with each other through first and second circuit nodes (k1, k2),

- a cascade circuit (1) serving for absorbing the voltage, which is inserted between the first and second circuit nodes (k1, k2) and comprises at least one p-channel transistor (t) provided in cascade arrangement,
- the at least one p-channel transistor (t) being connected with the first circuit node (k1) by means of its source terminal (S), with the second circuit node (k2) by means of its drain terminal (D), and with the associated output (o) of a bias source (2) by means of its gate terminal (G), the bias source generating a fixed potential (HV) at the gate of the at least one p-channel transistor (t) provided in cascade arrangement, which fixed potential lies between a positive supply voltage (VDD) and a negative supply voltage (VSS),
- the well terminal (W) of the at least one p-channel transistor (t) being connected with a terminal potential which is essentially equal to the respective source potential or is slightly higher than this, and
- the bias source (2) generating the fixed potential(s) (HV or V1, V2, V3) as a function of the level of the positive supply voltage (VDD) such that during a transient effect of the positive supply voltage (VDD), in which the increasing positive supply voltage (VDD) lies between a voltage value of 0V and a further voltage value which is equal to a second limit value (F), the fixed potential(s) (HV; V1, V2, V3) of the negative supply voltage (VSS) is/are equal, and that beyond of these voltage values (0V, F) with a growing level of the positive supply voltage (VDD), the fixed potential(s) (HV; V1, V2, V3) rises/rise with the supply voltage such that a voltage breakthrough will not occur with any voltage value of the positive supply voltage (VDD),

**characterised by** the following features:

- the first subcircuit (3; 3.1; 3.5) comprises between a terminal (4) for the positive supply voltage (VDD) and the first circuit node (k1) a p-channel transistor structure (to) embedded in a n-well (w) and having source, drain and gate regions (s, d and g, respectively), the n-well (w) being connected through a resistor (R; R'), serving for limiting the current in the event of a polarity reversal, with the source terminal (So) of the p-channel transistor structure (to), said source terminal being coupled by a low-impedance path to the positive supply voltage (VDD),
- the drain terminal (Do) of the p-channel transistor structure (to) is coupled to the first circuit node (k1), and
- the gate terminal (Go) of the p-channel transistor structure (to) is fed with one of the fixed potentials (VH; V1, V2, V3) from the bias source (2) in case of a switched protective circuit (3.5), and is fed with the output signal of a regulating circuit (7) in case of a regulated protective circuit (3.1), which regulates the output current (ih) coming from the regulated protective circuit (3.1) and flowing in particular through the cascade circuit (1).

2. The circuitry according to claim 1, **characterized in that** the bias source (2), at the latest when the maximum value of the positive supply voltage (VDD) is reached, sets the level of the fixed potential(s) (HV or V1, V2, V3) in such a manner that they define sections with essentially the same magnitude with regard to the supply voltage which is available in each case.

3. The circuitry according to claim 1, **characterised in that** the current regulated by means of the regulating circuit (7) is the operating current (ih) of a co-integrated Hall plate (5.1).

4. The circuitry according to any one of the claims 1 to 3, **characterised in that** the second subcircuit (5) comprises an analogue and/or digital signal processing circuit.

5. The circuitry according to any one of the claims 1 to 4, **characterised in that** the second subcircuit (5) comprises at least one voltage-proof n-channel transistor (tn).

6. The circuitry according to claim 1, **characterised in that** the protective circuit (3.1; 3.5) has its well terminal (Wo) connected with a Zener diode or with a field oxide transistor as an overvoltage protection element (se).

**Revendications**

1. Circuit (t0, 1) pour augmenter la tenue en tension d'un commutateur CMOS (3,5), qui contient au moins un premier et un second élément de circuit (3,5) dont les tensions de service sont différentes et qui sont couplés l'un à l'autre par un premier et un second noeuds de circuit (k1, k2) de sorte que :

- un circuit cascode (1) sert pour détecter la tension, en étant inséré entre le premier et le second noeuds de circuit (k1, k2) et qui comporte au moins un transistor (t) à canal p connecté en montage cascode,
- le dit au moins un transistor (t) à canal p est connecté au moyen de sa borne de source (S) avec le premier noeud de circuit (k1), sa borne de drain (D) étant connectée avec le deuxième noeud de circuit (k2) et sa borne de grille G) étant connectée avec la sortie correspondante (o) d'une source de tension de polarisation (2) qui génère à la grille d'au moins l'un des transistors (t) à canal p connectés en montage cascode un potentiel fixé (HV) dont la valeur appartient à l'intervalle compris entre une tension d'alimentation positive (VDD) et une tension d'alimentation négative (VSS),
- la connexion de caisson (W) d'au moins un transistor (t) à canal p est connectée à un potentiel de raccordement qui se trouve pratiquement au niveau du potentiel de source respective ou légèrement au-dessus, et

- la source de tension de polarisation (2) produit le ou les potentiels fixés (HV, et/ou V1, V2, V3) d'une manière qui dépend de la hauteur de la tension d'alimentation positive (VDD) qui, pendant l'exécution d'une commutation de la tension d'alimentation positive (VDD), suit une excursion de tension d'alimentation positive (VDD) entre la valeur de tension 0 V et une autre valeur de tension qui est égale à une deuxième valeur limite (F), le ou les potentiels fixés (HV ; V1, V2, V3) de la tension d'alimentation négative (VSS) étant égaux et qui est telle que, en dehors de ces valeurs de tension (0V, F) du ou des potentiels fixés (HV ; V1, V2, V3), le ou les potentiels fixés (HV ; V1, V2, V3) augmentent avec la valeur croissante de la tension d'alimentation positive (VDD) de sorte qu'aucune valeur de tension de la tension d'alimentation positive (VDD) ne subit un claquage en tension,

**caractérisé par** les caractéristiques suivantes :

- le premier élément de circuit (3 ; 3.1, 3.5) comporte dans un caisson de type "n" (w) l'introduction d'une structure de transistor (t0) de type à canal p disposé entre une connexion (4) pour la tension d'alimentation positive (VDD) et le premier noeud de circuit (k1) avec des zones de source, de drain et de grille (s, d, g) de sorte que le caisson de type "n" est relié par une résistance (R ; R'), qui sert de moyen de limitation de courant dans le cas d'une chute de polarisation, avec la connexion de source (So) de la structure de transistor (t0) à canal de type «p » qui est couplée par une faible résistance à la tension d'alimentation positive (VDD) ;
- la connexion de drain (Do) de la structure de transistor (to) à canal de type « p » est couplé au premier noeud de circuit (k1) et
- la connexion de grille (Go) de la structure de transistor (to) à canal de type « p » est alimentée au moyen de l'un des potentiels fixés (VH ; V1, V2, V3) de la source d'alimentation (2) et au moyen d'un circuit de protection (3.1) contrôlé avec le courant de sortie (ih) du circuit de protection contrôlé (3.1) qui circule en particulier dans le circuit monté en cascode (1).

2.  Circuit selon la revendication 1, **caractérisé en ce que** la source de tension de polarisation (2) est établie au plus tard quand la valeur du ou des potentiels fixés (HV et/ou V1, V2, V3) atteint la valeur maximale de la tension d'alimentation positive (VDD) de sorte que elles définissent la tension d'alimentation correspondante en cours selon des profils de valeurs relativement comparables.

3.  Circuit selon la revendication 1, **caractérisé en ce que** le courant de la source de courant de fonctionnement (ih) est régulé au moyen du circuit de contrôle (7) d'une plaque intégrée à effet Hall (5.1).

4.  Circuit selon l'une quelconque des revendications 1 à 3, **caractérisé en ce que** le second élément de circuit (5) comporte un circuit de traitement de signal analogique et/ou numérique.

5.  Circuit selon l'une quelconque des revendications 1 à 4, **caractérisé en ce que** le second élément de circuit (5) comporte au moins un transistor (tn) à canal « n » à tension invariable.

6.  Circuit selon la revendication 1, **caractérisé en ce que** le circuit de protection (3.1 ; 3.5) est connecté par sa connexion de caisson (Wo) au moyen d'une diode Zener ou au moyen d'un transistor à effet de champ à titre d'élément (se) de protection contre les surtensions.

Fig.1

Fig.2

Fig. 3

Fig. 4

Fig.5

Fig.6

Fig.7

Fig.8

Fig.9

EP 0 648 019 B1